# EUROPEAN PATENT APPLICATION

(11) **EP 2 492 898 A2**
(43) Date of publication of application: **29.08.2012**
(21) Application number: 12155594.0
(22) Date of filing: 15.02.2012
(51) Int. Cl.: G09F 9/33, H05B 33/08, F21K 99/00, H01L 25/075, H01L 33/58

(54) **Light Emitting Device**

(30) Priority: 22.02.2011 JP 2011036435
(71) Applicant: Panasonic Corporation, Osaka 571-8501 (JP)
(72) Inventor: Tanaka, Kenichiro, Neyagawa, Osaka (JP)
(74) Representative: Rüger, Barthelt & Abel

(57) **Abstract**

[Object] To intend to reduce color unevenness in a light emitting device for mixing lights of plurality of colors to be emitted.

[Means for Settlement] A light emitting device 1 includes a light emitting part 2(R) that converts a blue light from a LED 21 to a red light by red fluorescent substances 23 and derives the red light, a light emitting part 2(G) that converts the blue light to a green light by green fluorescent substances 24 and derives the green light, and a light emitting part 2(B) that transmits the blue light as it is. The light emitting parts 2(R), 2(G) and 2(B) are arranged to be adjacent to one another, and the red fluorescent substances 23 and green fluorescent substances 24 are distributed in the sealing members 22 for the LEDs 21 in the light emitting parts 2(R) and 2(G), respectively. The light emitting device 1 is further provided with a light diffusion part 7 for covering the light emitting parts 2(R), 2(G) and 2(B) in common. The red, green and blue lights emitted from the light emitting parts 2(R), 2(G) and 2(B) are intermixed not only in the light diffusion part 7 but also before reaching the light diffusion part 7. Consequently, the lights derived from the light emitting device 1 become white lights while the color unevenness is fully reduced.

## Description

### [Field of the Invention]

The present invention relates to a light emitting device for emitting a light by mixing lights of a plurality of colors.

### [Background Art]

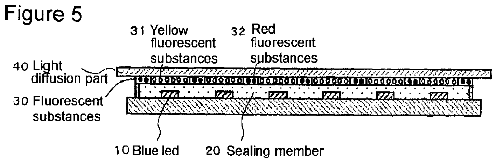

Conventionally, there has been known a light emitting device for emitting lights of a plurality of colors using a plurality of solid light-emitting elements such as a plurality of LEDs (Light Emitting Diodes) as a light source (see, e.g., Patent Literature 1). Such a light emitting device includes a plurality of blue LEDs 10, a sealing member 20 for collectively sealing the blue LEDs 10, and a fluorescent substance layer 30 provided in contact with a light derivation surface of the sealing member 20 as shown in Fig. 5. The fluorescent substance layer 30 is provided with yellow light emitting regions 31 each of which includes a yellow fluorescent substance for emitting a yellow light excited by the blue light emitted by each of the blue LEDs 10 and red light emitting regions 32 each of which includes a red fluorescent substance for emitting a red light excited by the blue light emitted by each of the blue LEDs 10. The yellow and red lights emitted by these regions are inputted to a light diffusion part 40 where the inputted lights are diffused in various directions so as to be intermixed.

### [Conventional Technique Document]

### [Patent Literature]

[Patent Literature 1] JP2010-123918A

### [Disclosure of the Invention]

### [Problems to be solved by the Invention]

However, in the light emitting device of Patent Literature 1, since the fluorescent substance layer 30 and the light diffusion part 40 are close to each other, the yellow and red lights generated in the fluorescent layer 30 are substantially mixed to each other only in the light diffusion part 40. Therefore, the mixture of the lights is insufficient and there is a fear that color unevenness cannot be fully reduced.

The present invention has been made to solve the problem mentioned above, and an object thereof is to provide a light emitting device capable of fully reducing color unevenness at a time of emitting a light by mixing lights of a plurality of colors.

### [Means adapted to solve the Problems]

The light emitting device of the present invention includes: a plurality of light emitting parts each of which includes a solid light-emitting element and a sealing member for sealing the solid light-emitting element wherein the sealing member wavelength-converts a light emitted from the solid light-emitting element by fluorescent substances and then derives the resultant light or transmits the light as it is without including a fluorescent substance; activation drivers for controlling the light emission of the plurality of light emitting parts; and a light diffusion part covering the plurality of light emitting parts in common, wherein the plurality of light emitting parts are arranged to be adjacent to one another and at least a part of the adjacent light emitting parts is configured to emit lights of different colors to each other, and wherein each of the plurality of activation drivers is commonly provided for the light emitting parts that emit the lights of the same color to be derived from the sealing member among the plurality of light emitting parts so as to control the light emission of the light emitting parts, respectively.

Preferably, the light diffusion part is provided with the fluorescent substances on the surface or the reverse surface or inside thereof.

Preferably, the light diffusion part is provided with a fluorescent sheet adhered to the surface or the reverse surface thereof.

Preferably, the plurality of light emitting parts is arranged on a wiring board in an array or matrix shape.

Preferably, the light diffusion part is formed in a plate shape having a larger size than that necessary for covering the plurality of light emitting parts in common.

Preferably, the wiring board is provided with a high reflective layer, an electrically conductive circuit layer and an insulating heat dissipation layer in this order from a side of mounting the solid light-emitting elements.

Preferably, the high reflective layer has its surface including a high light reflective member with 80% or more light reflectance.

Preferably, the colors of the lights derived from the plurality of light emitting parts are three primary colors of light.

### [Effect of the Invention]

According to the light emitting device of the present invention, in the case where a light emitting part including the fluorescent substances in the sealing member for the solid light-emitting element and a light emitting part including no fluorescent substance are adjacent, the lights of colors different from each other emitted from these light emitting parts are mixed not only in the light diffusion part but also before reaching the light diffusion part. Therefore, color unevenness of lights irradiated to the outside from the light diffusion part can be fully reduced.

### [Brief Description of Drawings]

[Fig. 1] Fig. 1 is a plan view of a light emitting device pertaining to a first embodiment of the present invention.
[Fig. 2] Fig. 2 is a section view across an I-I line in Fig. 1.
[Fig. 3] Figs. 3 (a), (b) and (c) are respectively section views of light emitting devices pertaining to modified examples of the above embodiment.
[Fig. 4] Fig. 4 is a plan view of a light emitting device pertaining to a second embodiment of the present invention.
[Fig. 5] Fig. 5 is a longitudinal section view of a conventional light emitting device.

### [Best Mode for Carrying Out the Invention]

A light emitting device pertaining to an embodiment of the present invention is described below referring to the drawings. The light emitting device of the present embodiment uses an LED as a solid light-emitting element.

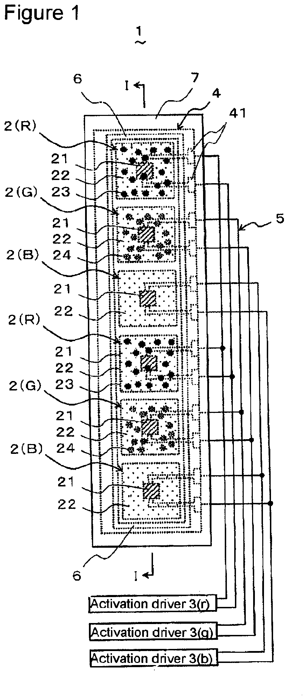

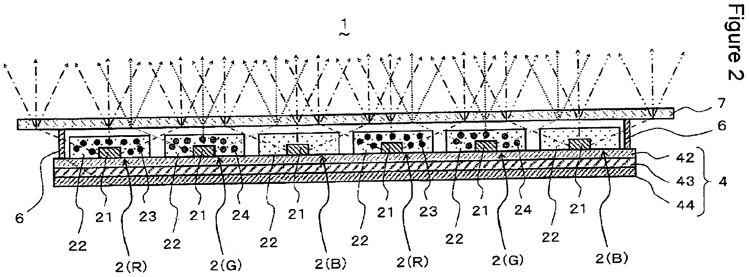

As shown in Figs. 1 and 2, the light emitting device 1 is a linear-shaped light emitting device that includes a plurality of light emitting parts 2 which are adjacent to each other and arranged in an array (linear shape) and a plurality of activation drivers 3 adapted to control the light emission of these light emitting parts 2. These light emitting parts 2 are mounted on a wiring board 4 and electrically connected to the specified activation drivers 3 through wiring patterns 41 of the wiring board 4 and distribution lines 5 provided for the respective light emitting parts 2. A supporting member 6 for collectively surrounding the light emitting parts 2 is arranged around the plurality of light emitting parts 2 in a state of being adhered onto the wiring board 4. The supporting member 6 holds a light diffusion part 7 for covering the plurality of light emitting parts 2 in common on a surface of an opposite side to a surface contacting the wiring board 4.

Each of the light emitting parts 2 includes one LED 21 and a sealing member 22 for sealing the LED 21. The LED 21 includes a blue LED for emitting a blue light having a peak wavelength of approximately 460 nm. As the sealing members 22, there are ones including red fluorescent substances 23 for emitting red lights excited by the blue light from the LED 21, ones including green fluorescent substances 24 for emitting green lights excited by the blue light from the LED 21 and ones including no fluorescent substance. The light emitting part 2 (R: red) including the red fluorescent substances 23 in the sealing member 22 wavelength-converts the blue light from the LED 21 to the red light by the red fluorescent substances 23 so that the resultant red light is derived. The light emitting part 2 (G: green) including the green fluorescent substances 24 in the sealing member 22 wavelength-converts the blue light from the LED 21 to the green light by the green fluorescent substances 24 so that the resultant green light is derived. The light emitting part 2 (B: blue) including no fluorescent substance in the sealing member 22 transmits the blue light from the LED 21 as it is. These light emitting parts 2(R), 2(G) and 2(B) are arranged on the wiring board 4 in an array (linear shape) in a repetition pattern of an arrangement in the order of the light emitting parts 2(R), 2(G) and 2(B) so that the respective adjacent light emitting parts emit the lights of colors different from each other. Herein, it may be sufficient that the light emitting parts 2(R), 2(G) and 2(B) are arranged in a manner that at least a part of the respective adjacent parts emits the lights of colors different from each other, and the arrangement of the light emitting parts 2(R), 2(G) and 2(B) is not limited to that of the present embodiment. Moreover, the LED 21 is not limited to the blue LED, and an LED emitting a light of an ultraviolet - violet - blue - cyan and the like colors may be used, and the sealing member 22 may include fluorescent substances other than the red fluorescent substances 23 and the green fluorescent substances 24 or also may include a plurality of fluorescent substances. For example, by combining an LED for emitting an ultraviolet - violet light and a blue fluorescent LED for emitting a blue light excited by the light from this LED, the light emitting part 2 for emitting a blue light may be configured. Moreover, the kind of the LED 21 may be different every individual light emitting parts 2, and also a plurality of LEDs may be included in one light emitting part 2.

The LED 21 is formed in a size of approximately 0.3 mm square and includes a nitride material such as indium gallium nitride (InGaN) and the like material. In addition, the size and composing material of the LED 21 are not limited to those of the above examples.

The sealing member 22 has a refractive index of 1.2 to 1.7 and includes a heat-resistant material with light-transmitting properties such as, e.g., transparent silicon resin or transparent silicon rubber, acrylic resin, transparent glass or transparent ceramic. In the sealing member 22 of the light emitting part 2(B), there may be dispersed a light dispersion material (although not shown) for dispersing a light. Herein, in the present embodiment, although the sealing member 22 is formed to have a rectangular parallelepiped outline, it is not limited to a rectangular parallelepiped and may be, e.g., a hemisphere shape or a half-elliptic shape.

Each of the plurality of activation drivers 3 is provided so as to be in common to the light emitting parts 2 deriving lights of the same color from the sealing members 22 among the light emitting parts 2(R), 2(G) and 2(B). In the present embodiment, the activation driver 3(R) is provided for the light emitting parts 2(R), the activation driver 3(G) is provided for the light emitting parts 2(G), and the activation driver 3(B) is provided for the light emitting parts 2(B). These activation drivers 3(R), 3(G) and 3(B) are connected to a commercial power source (not shown) and also electrically connected to the LEDs 21 of the corresponding light emitting parts 2, respectively through the wiring patterns 41 of the wiring board 4 and the distribution lines 5. The activation drivers 3(R), 3(G) and 3(B) are provided with switches and microcomputers so as to control power supply to the light emitting parts 2(R), 2(G) and 2(B), respectively.

The wiring board 4 is formed to have a long size of 270mm × 30mm and includes, e.g., a metal such as aluminum, a resin such as glass epoxy or ceramics as a base material. Herein, the size, shape and composing material of the wiring board 4 are not limited to those mentioned above. Moreover, the wiring board 4 is provided with a casing so that the wiring board 4 is attached to a ceiling and a wall etc. through a holding structure provided in the casing.

The wiring board 4 has a three-layer structure as shown in Fig. 2 and is provided with a high reflective layer 42, an electrically conductive circuit layer 43 and an insulating heat dissipation layer 44 in this order from a side of mounting the LEDs 21. The high reflective layer 42 preferably has a surface thereof that includes a high light-reflection member with a light reflectance of 80% or more such as silver or aluminum. The electrically conductive circuit layer 43 is provided with the wiring patterns 41 (see Fig. 1) including such as silver foil. The insulating heat dissipation layer 44 includes an epoxy resin, a glass epoxy resin or the like with high electrical insulating properties and heat conductivity.

The supporting member 6 has a rectangular shape in a top plan view and includes a heat resistant resin material with light-transmitting properties such as a transparent silicon resin or epoxy resin material. The supporting member 6 preferably has a refractive index in the same degree as that of the sealing member 22. Herein, the shape of the supporting member 6 is not limited to a rectangular and also may be an ellipse.

The light diffusion part 7 includes, e.g., a transparent material such as silicon resin or glass containing powdery substances including such as silicon dioxide or ceramics dispersed therein, or a material such as glass or acrylic resin formed with asperities at least on one of top and bottom surfaces by a frost process or the like. The light diffusion part 7 has a linear transmittance of 50% or less and is formed to be plate-shaped with a size larger than that necessary for covering the light emitting parts 2(R), 2(G) and 2(B) in common. The light diffusion part 7 is adhered to the supporting member 6 with a light-transmitting adhesive having components of silicon resin, epoxy resin or the like.

Next, an action of the light emitting device 1 configured as described above is described below. The light emitting parts 2(R), 2(G) and 2(B) of the light emitting device 1 emit a red light, a green light and a blue light, respectively. Thus, the colors of the lights derived from these light emitting parts 2(R), 2(G) and 2(B) become the three primary colors of light. As shown in Fig. 2, the blue light (shown by a one-dot dashed arrow mark) emitted from the LED 21 of the light emitting part 2(R) is wavelength-converted to a red light by the red fluorescent substances 23 in the sealing member 22 so that the resultant light reaches the light diffusion part 7. Similarly, the blue light (shown by a dotted arrow mark) emitted from the LED 21 of the light emitting part 2(G) is wavelength-converted to a green light by the green fluorescent substances 24 in the sealing member 22 so that the resultant light reaches the light diffusion part 7. Meanwhile, the blue light (shown by a two-dot dashed arrow mark) emitted from the LED 21 of the light emitting part 2(B) is transmitted through the sealing member 22 as it is so as to reach the light diffusion part 7. In this configuration, since the light emitting parts 2(R), 2(G) and 2(B) are arranged to be adjacent to one another, these red light, green light and blue light are intermixed before reaching the light diffusion part 7. The mixed lights are then diffused in various directions in the light diffusion part 7 so as to be further mixed. Consequently, white lights are obtained with the color unevenness fully reduced so as to be derived from the light diffusion part 7.

By dispersing light diffusing substances (not shown) in the sealing member 22 of the light emitting part 2(B), it is possible to increase a light irradiation angle of the blue light derived from the light emitting part 2(B). Thus, the blue light from the light emitting part 2(B) and the red and green lights from the light emitting parts 2(R) and 2(G) which are adjacent to the light emitting part 2(B) can be mixed in color more intensely, and therefore it becomes possible to obtain the white light derived from the light diffusion part 7 with the color unevenness thereof further reduced.

The optical characteristic of the white light derived from the light diffusion part 7 can be dimmed by performing on/off control or dimming-control of the light emission of the light emitting parts 2(R), 2(G) and 2(B) every light emitting parts 2 by the activation drivers 3(R), 3(G) and 3(B). Thus, the color tone and brightness of the white light derived from the light diffusion part 7 can be freely adjusted. For example, by intensifying the light emission of the light emitting part 2(R) to increase the red light component and lowering the light emission of the light emitting part 2(B) to reduce the blue light component, there can be obtained a reddish warm white light approximate to an incandescent lamp. Moreover, the color tone and brightness of the light derived from the light diffusion part 7 can be adjusted by changing such as a kind, concentration of the fluorescent substances dispersed in the sealing member 22 and concentration ratio with respect to the other fluorescent substances.

Since the light diffusion part 7 is formed to have a size larger than that necessary for covering the light emitting parts 2(R), 2(G) and 2(B) in common, these light emitting parts 2(R), 2(G) and 2(B) can be masked from a user of the light emitting device 1. Thus, since the emitted lights of the light emitting parts 2(R), 2(G) and 2(B) cannot be directly viewed from the user, a circumferential portion of the light emitting device 1 becomes inconspicuous so that the appearance of the light emitting device 1 can be enhanced. Also, by forming the light diffusion part 7 to be a simple plate shape, the production thereof can be facilitated.

In the case where the light diffusion part 7 includes such as a glass or acrylic resin of relatively high hardness, the light diffusion part 7 can be functioned not only as a light diffusion member but also as an outer shell member for protecting the light emitting device 1 from an impact and the like.

Apart of the lights diffused by the light diffusion part 7 may be likely returned inward of the light emitting device 1. Such so-called return lights are reflected by the high reflective layer 42 on the surface of the wiring board 4 and may travel outward of the light emitting device 1 again. Thus, the efficiency of the light derivation of the light emitting device 1 can be improved.

The insulating heat dissipation layer 44 of the wiring board 4 dissipates heat generated in the light emitting device 1 due to the light emission of the LEDs 21 and the like. Thus, an abnormal temperature rise in the light emitting device 1 can be prevented so that a stable operation of the light emitting device 1 can be ensured.

Since the refractive index of the sealing member 22 is made in the same degree of that of the supporting member 6, a lighting loss at the time of the lights emitted from the LEDs 21 passing through these members can be reduced.

In the light emitting device 1, each of the plurality of LEDs 21 is individually sealed with the sealing member 22 so as to form one independent light emitting part 2. Therefore, even if a malfunction is caused in one of the light emitting parts 2, only the defective light emitting part 2 can be exchanged. Whereas, in the light emitting device of Patent Literature 1 as shown in Fig. 5, since the plurality of LEDs are collectively sealed , when a malfunction occurs in one of the LEDs, it is difficult to change only the defective LED. Therefore, by constructing the light emitting device 1 provided with the plurality of light emitting parts 2 independently from each other as described above, when a malfunction occurs in one of the light emitting parts 2, it becomes possible to deal with the malfunction efficiently at a lower cost.

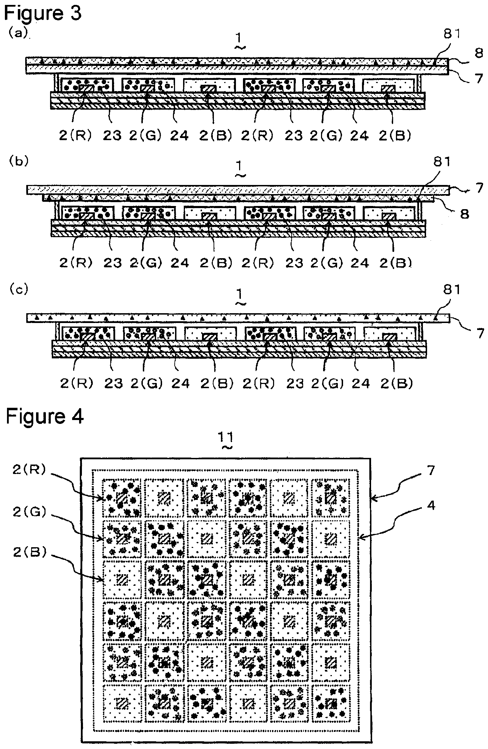

Modified examples of the light emitting device 1 of the present embodiment are shown in Figs. 3(a), (b) and (c). The light emitting device 1 shown in Fig. 3(a) is provided with a fluorescent substance layer 8 which includes fluorescent substances 81 on the surface (on a side of a light derivation surface) of the light diffusion part 7. Meanwhile, the light emitting device 1 shown in Fig. 3(b) is provided with a fluorescent substance layer 8 which includes fluorescent substances 81 on the back surface (on a side of a light incident surface) of the light diffusion part 7. Further, the light emitting device 1 shown in Fig. 3(c) is provided with a fluorescent substance layer 8 which includes fluorescent substances 81 inside the light diffusion part 7. Herein, the fluorescent substances 81 may be different from the red fluorescent substances 23 and green fluorescent substances 24 or may be the red fluorescent substances 23 and green fluorescent substances 24. Also, two or more kinds of fluorescent substances may be provided as the fluorescent substances 81.

The fluorescent substances 81 adjust light properties of the white light derived from the light diffusion part 7. For example, by using the green fluorescent substances 24 as the fluorescent substances 81, there can be obtained a white light of high color rendering properties subjected to supplemental lighting with a green light as the white light derived from the light diffusion part 7. Moreover, the fluorescent substances 81 can also correct irradiation light intensity unevenness and color unevenness etc. of the light emitting parts 2(R), 2(G) and 2(B) due to unevenness of optical characteristics of the LEDs 21.

The fluorescent substances 81 may include a fluorescent sheet adhered to the surface of the light diffusion part 7 or a fluorescent sheet adhered to a back surface of the light diffusion part 7. Thus, the fluorescent substances 81 can be simply and easily arranged on the light diffusion part 7. Moreover, the fluorescent substances 81 may be directly printed on the surface or back surface of the light diffusion part 7 by a screen printing and the like.

According to the modified examples of the present embodiment, it is possible to irradiate mixed color lights with the color unevenness fully reduced and there can be obtained a linear shaped light emitting device capable of controlling optical characteristics of the mixed color lights every light of the respective colors.

Next, a light emitting device pertaining to a second embodiment of the present invention is described below referring to Fig. 4. The light emitting device 11 is a plane-shaped light emitting device that includes a rectangular wiring board 4, a plurality of light emitting parts 2(R), 2(G) and 2(B) arranged in a matrix shape (plane shape) to be adjacent to one another on the wiring board 4 and a light diffusion part 7 covering the light emitting parts 2 in common. The light emitting device 11 has the same structure as that of the light emitting device 1 except that the arrangement of the light emitting parts 2(R), 2(G) and 2(B) on the wiring board 4 is different.

The light emitting parts 2(R), 2(G) and 2(B) are arranged in a manner that the same kind of the light emitting parts 2 are not respectively arranged immediately upper and lower positions and immediately right and left positions adjoining thereto, whereby the light emitting parts 2 are distributed uniformly. In the present embodiment, although the light emitting parts 2(R), 2(G) and 2(B) are arranged every 12 in number thereof (i.e., 36 in total) in a matrix shape of 6 in column × 6 in row, the number and arrangement of the light emitting parts 2(R), 2(G) and 2(B) are not limited to those of the present embodiment. Moreover, in the present embodiment, although the light emitting device 11 is provided with the three kinds of the light emitting parts 2(R), 2(G) and 2(B) as the light emitting parts 2, it may be provided with four or more kinds of the light emitting parts 2. Herein, in Fig. 4, the activation drivers, distribution lines, wiring patterns and supporting member are not shown for simplifying the drawing.

Similarly to the case of the light emitting device 1 of the first embodiment, the lights emitted from the light emitting parts 2(R), 2(G) and 2(B) are respectively intermixed with the lights of different colors emitted from the adjacent light emitting parts 2, and as a result, there can be obtained a white light with the color unevenness fully reduced.

According to the present embodiment, it is possible to obtain a plane-shaped light emitting device irradiating the lights of mixed colors with the color unevenness fully reduced.

In addition, the light emitting device of the present invention is not limited to the above embodiments and various changes and modifications thereof can be performed. For example, the solid light-emitting element for use in the present light emitting device is not limited to an LED, and an organic EL (electro-luminescent) element etc. may be used. Moreover, in the present embodiments, the light emitting device is adapted to irradiate a white light, it may be adapted to irradiate a light of another color by combining the solid light emitting elements and the fluorescent substances in various manners. Further, by incorporating a time controller etc. into the present light emitting device, the light irradiation may be varied with time lapse.

### [Description of Reference Numerals]

- 1, 11: Light emitting device
- 2, 2(R), 2(G), 2(B): Light emitting part
- 21: Solid light emitting element (LED)
- 22: Sealing member
- 23: (red) Fluorescent substances
- 24: (green) Fluorescent substances
- 3, 3(R), 3(G), 3(B): Activation driver
- 4: Wiring board
- 42: High reflective layer
- 43: Electrically conductive circuit layer
- 44: Insulating heat dissipation layer
- 7: Light diffusion part
- 81: Fluorescent substances (for adjusting light properities)

## Claims

1. A light emitting device comprising:
a plurality of light emitting parts each of which includes a solid light-emitting element and a sealing member for sealing the solid light-emitting element wherein the sealing member wavelength-converts a light emitted from the solid light-emitting element by fluorescent substances and then derives the resultant light or transmits the light as it is without including a fluorescent substance;
activation drivers for controlling the light emission of the plurality of light emitting parts; and
a light diffusion part covering the plurality of light emitting parts in common,
wherein the plurality of light emitting parts are arranged to be adjacent to one another and at least a part of the adjacent light emitting parts is configured to emit lights of difference colors to each other, and
wherein each of the plurality of activation drivers is commonly provided for the light emitting parts that emit the lights of the same color to be derived from the sealing member among the plurality of light emitting parts so as to control the light emission of the light emitting parts, respectively.

2. The light emitting device according to claim 1, wherein the light diffusion part is provided with the fluorescent substances on the surface or reverse surface or inside thereof.

3. The light emitting device according to claim 2, wherein the light diffusion part is provided with a fluorescent sheet adhered to the surface or reverse surface thereof.

4. The light emitting device according to any one of claims 1 to 3, wherein the plurality of light emitting parts are arranged on a wiring board in an array or matrix shape.

5. The light emitting device according to claim 4, wherein the light diffusion part is formed in a plate shape having a larger size than that necessary for covering the plurality of light emitting parts in common.

6. The light emitting device according to claim 4 or 5, wherein the wiring board is provided with a high reflective layer, an electrically conductive circuit layer and an insulating heat dissipation layer in this order from a side of mounting the solid light-emitting elements.

7. The light emitting device according to claim 6, wherein the high reflective layer has its surface including a high light reflective member with 80% or more light reflectance.

8. The light emitting device according to any one of claims 1 to 7, wherein the colors of the lights derived from the plurality of light emitting parts are three primary colors of light.
